# EUROPEAN PATENT APPLICATION

(11) **EP 1 672 969 A1**
(43) Date of publication of application: **21.06.2006**
(21) Application number: 04792343.8
(22) Date of filing: 06.10.2004
(51) Int. Cl.: H05K 1/05

(54) **SUBSTRATE AND METHOD FOR PRODUCING SAME**

(30) Priority: 07.10.2003 JP 2003347904
(71) Applicant: Neomax Materials Co., Ltd., Suita-shi, Osaka 564-0043 (JP)
(72) Inventor: KIKUI, Fumiaki, Suita-shi, Osaka 5640043 (JP); MORISHITA, Akio, Suita-shi, Osaka 5640043 (JP); YASUOKA, Masato, Suita-shi, Osaka 5640043 (JP)
(74) Representative: Grünecker, Kinkeldey, Stockmair & Schwanhäusser Anwaltssozietät
(86) International application number: PCT/JP2004/015108
(87) International publication number: WO 2005/036939

(57) **Abstract**

A substrate according to the present invention includes a metal plate, and an insulating film, which is provided on the surface of the metal plate and which includes needle alumina particles and granular particles. The substrate of the present invention has excellent insulating property and can be manufactured on an industrial basis with acceptable efficiency.

## Description

### TECHNICAL FIELD

The present invention relates to a substrate for use to make a wiring board and a method of making such a substrate. More particularly, the present invention relates to a substrate that uses a metal plate as its base substrate and a method of making such a substrate.

### BACKGROUND ART

In making a wiring board for an electronic device, a resin substrate made of an epoxy resin, for example, a ceramic substrate, or a metal base substrate may be used. Among other things, the metal base substrate has higher mechanical strength, higher machinability, and greater patternability than the resin substrate or the ceramic substrate. That is to say, the metal base substrate can be formed into any desired shape relatively easily.

A metal plate has electrical conductivity. That is why in a metal base substrate that uses a metal plate as its base substrate, a wiring pattern should be provided on an insulating film that has been formed on the surface of the metal plate. The insulating film to be deposited on the surface of the metal plate may be a polyimide film, a polyamide film or any other suitable organic insulating film (see Japanese Patent Application Laid-Open Publication No. 6-104542, for example).

However, the polyimide or polyamide film has low heat resistance (e.g., can resist a heat of just 350 °C). Therefore, a metal base wiring board, including such an organic insulating film on its surface, has only limited applications and processing temperatures. For example, when applied to a control panel for cars, the wiring board sometimes needs to have a heat resistance of 500 °C or more. In that case, the metal base wiring board including such an organic insulating film cannot be used. Also, once the insulating film has been deposited on the metal plate, the wiring board including the organic insulating film cannot be subjected to a press process anymore.

Meanwhile, an inorganic insulating film of aluminum oxide or silicon dioxide has excellent heat resistance. However, each of these films is usually formed by a sputtering process, which takes a long time to deposit the film. For example, to deposit a film to a thickness of 0.3 *µ* m or more on a base substrate by a sputtering process, the deposition process must be carried out for at least 10 hours. Such a lengthy deposition process cannot be carried out industrially with acceptable efficiency.

### DISCLOSURE OF INVENTION

In order to overcome the problems described above, an object of the present invention is to provide a substrate, on which an inorganic film with excellent insulating property has been formed on the surface of a metal plate and which can be manufactured on an industrial basis with acceptable efficiency.

A substrate according to the present invention includes a metal plate, and an insulating film, which is provided on the surface of the metal plate and which includes needle alumina particles and granular particles, whereby the problems described above are overcome.

The granular particles may include at least one of silica particles, MgO particles, and TiO₂ particles.

In one preferred embodiment, the granular particles include silica particles.

The needle alumina particles preferably have an aspect ratio of 6 to 15.

The needle alumina particles preferably have a major-axis length of 70 nm to 300 nm.

The granular particles preferably have a mean particle size of 5 nm to 80 nm.

The insulating film preferably includes 0.3 mass% to 80 mass% of the needle alumina particles.

The insulating film preferably has a thickness of 0.3 µm to 3.5 µm.

The insulating film preferably has a surface roughness of 0.3 µm or less.

The metal plate may be made of Cu, an Fe-Ni-Cr alloy, an Fe-Cr alloy, an Fe-Ni alloy, Fe or Al.

The metal plate preferably has a thickness of 0.05 mm to 0.5 mm.

In a preferred embodiment, a wiring board includes a substrate according to any of the preferred embodiments of the present invention described above, and a wiring pattern that has been formed on the surface of the insulating film on the substrate.

A method of making a substrate according to the present invention includes the steps of: preparing a dispersion solution including needle alumina particles and granular particles; applying the dispersion solution onto a metal plate; drying the metal plate on which the dispersion solution has been applied; and baking the metal plate that has been subjected to the step of drying, thereby forming an insulating film on the surface of the metal plate, whereby the problems described above are overcome.

The step of applying the dispersion solution is preferably carried out by a coating process. Specifically, a process in which a metal plate is dipped in a dispersion solution and then lifted, thereby forming an insulating film on the metal plate (i.e., a dip coating process) may be adopted.

The dispersion solution is preferably prepared so as to have a PH of 3.5 to 5.5.

The dispersion solution may include at least one of formic acid, acetic acid, salts thereof, and ammonia.

The combined concentration of the needle alumina particles and the granular particles in the dispersion solution is preferably 2 mass% to 6 mass%.

In a preferred embodiment, the granular particles include silica particles.

The needle alumina particles preferably have an aspect ratio of 6 to 15.

The granular particles preferably have a mean particle size of 5 nm to 80 nm.

The insulating film preferably includes 0.3 mass% to 80 mass% of the needle alumina particles.

According to the present invention, an insulating film is formed on a metal base substrate using needle alumina particles and granular particles, thereby manufacturing a substrate, including an inorganic film with excellent insulating property on the surface of a metal plate, on an industrial basis with acceptable efficiency.

### BRIEF DESCRIPTION OF DRAWINGS

FIG. **1(a)** is an SEM photograph showing the surface of an insulating film on a substrate according to a preferred embodiment of the present invention.
FIG. **1(b)** schematically shows its structure.
FIG. **2** is an SEM photograph showing the surface of an insulating film consisting essentially of silica particles.

### BEST MODE FOR CARRYING OUT THE INVENTION

As described above, in the prior art, an inorganic insulating film cannot be formed on the surface of a metal plate by a manufacturing process that results in industrially acceptable efficiency. Thus, the present inventors researched a method of forming an inorganic insulating film on the surface of a metal plate by using fine inorganic particles as a material for the insulating film. However, simply by making an insulating film of particles, pinholes are just created through the insulating film, and an inorganic film with high insulating property cannot be obtained. To overcome this problem, the present inventors researched even more intensively. As a result, we discovered that a pinhole free inorganic film with high insulating property can be obtained by making an insulating film of needle alumina particles and granular particles in combination, thus acquiring the basic idea of the present invention.

A substrate according to a preferred embodiment of the present invention includes a metal plate, and an insulating film, which is provided on the surface of the metal plate and which includes needle alumina particles and granular particles. As used herein, the "needle alumina particle" is a particle that has a major axis and a minor axis and has an elongated shape just like a needle. On the other hand, the granular particles do not include needle particles or scale particles but spherical particles and particles in indefinite shapes, for example.

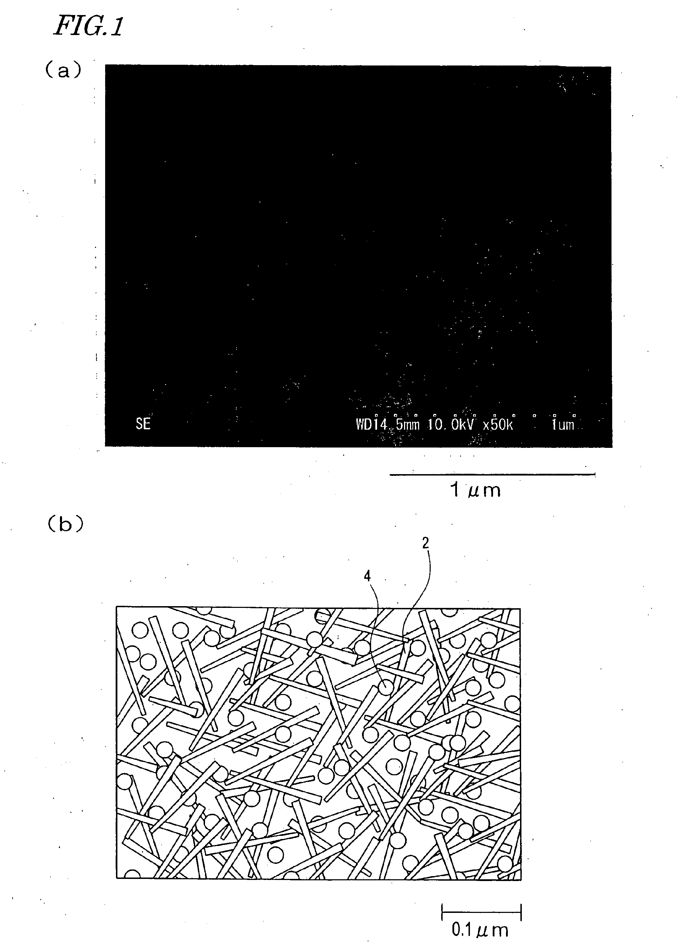

FIG. **1(a)** is an SEM photograph showing the surface of an insulating film on a substrate according to a preferred embodiment of the present invention. FIG. 1(b) schematically shows its structure.

This insulating film includes needle alumina particles 2 (with a major-axis length of 100 nm and an aspect ratio of 10) and silica particles 4 (spherical particles with a mean particle size of 30 nm) as the granular particles. This insulating film is designed so as to include the needle alumina particles and silica particles at a mass percentage ratio of seven to three.

As can be seen from FIGS. **1(a)** and 1**(b),** the silica particles are interwoven with a mesh formed by the needle alumina particles, thereby realizing a highly dense structure with a small number of gaps. It can also be seen that in the insulating film, both the needle alumina particles and silica particles are distributed uniformly to form that highly dense structure with a small number of gaps almost all over the insulating film. The insulating film of this substrate has excellent physical properties. More specifically, even if the substrate is bent, the insulating film does not peel off the metal plate easily. In addition, the insulating film has superb heat resistance and insulating property. Besides, since particles are used as a material for the insulating film, the insulating film can be deposited with a particle dispersion solution, and the substrate can be mass-produced on an industrial basis. On top of that, the substrate can be made easily by a simple manufacturing process, which will be described more fully later.

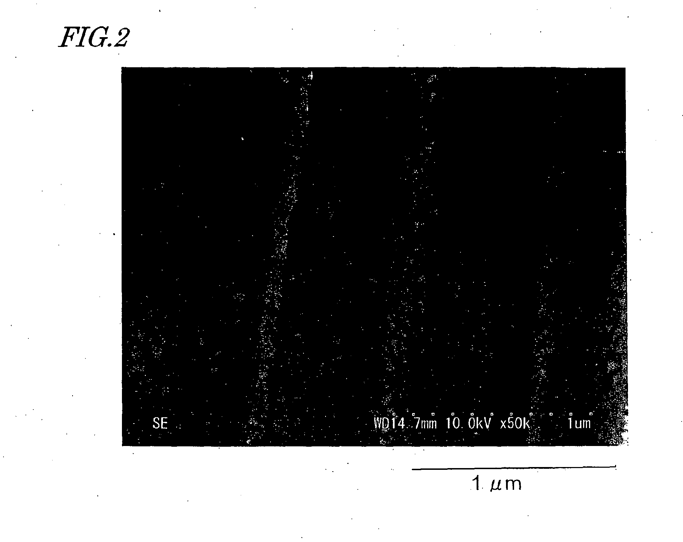

For the purpose of comparison, an SEM photograph showing the surface of an insulating film including no needle alumina particles but consisting essentially of silica particles (spherical particles with a mean particle size of 30 nm) only is shown in FIG. 2. If the insulating film includes no needle alumina particles but consists essentially of granular particles only, gaps are created here and there as shown in FIG. 2 as if no particles were present locally. Consequently, pinholes are created in the resultant insulating film, which cannot exhibit sufficient insulating property and heat resistance.

Although not shown, the surface of an insulating film, consisting essentially of needle alumina particles alone, was also observed with an SEM. As a result, the present inventors discovered that gaps were created between the needle alumina particles. Consequently, the resultant insulating film had a lot of pinholes, could not make a close contact with the substrate, and could not exhibit sufficient insulating property or heat resistance, either.

In contrast, it can be seen that by combining the needle alumina particles and granular particles, the needle alumina particles and granular particles form a highly dense and uniform fine structure, thereby realizing an inorganic film with excellent insulating and other physical properties.

The granular particles may include not only the silica particles described above but also MgO particles, TiO₂ particles, or a mixture thereof.

If the aspect ratios of the needle alumina particles are controlled, then the needle alumina particles and granular particles can be distributed uniformly almost all over the insulating film. As a result, a highly dense structure with a small number of gaps can be formed by the needle alumina particles and granular particles in substantially the entire insulating film as described above. More specifically, the needle alumina particles preferably have an aspect ratio (i.e., the ratio of the major-axis length to the minor-axis length) of 6 to 15. The reasons are as follows. If the aspect ratio were less than 6, then particles might aggregate together in a portion of the insulating film. However, if the aspect ratio exceeded 15, then the needle alumina particles and granular particles might separate from each other.

Not just the aspect ratios of the needle alumina particles but also the major-axis lengths of the needle alumina particles and the mean particle size of the granular particles do affect the fine structure formed in the insulating film. To get the highly dense structure with just a small number of gaps formed by the needle alumina particles and granular particles almost all over the insulating film as described above, the needle alumina particles preferably have a major-axis length of 70 nm to 300 nm. The reasons are as follows. Specifically, if the major-axis length were less than 70 nm, then the particles might aggregate together. However, if the major-axis length exceeded 300 nm, then huge gaps could be created between the particles to possibly make pinholes through the insulating film. Also, the granular particles preferably have a mean particle size of 5 nm to 80 nm. This is because if the mean particle size were less than 5 nm, then the needle alumina particles would aggregate together and the needle alumina particles and granular particles might separate from each other. On the other hand, if the mean particle size were greater than 80 nm, then huge gaps could be created between the particles to possibly make pinholes through the insulating film.

Likewise, the percentages of the needle alumina particles and granular particles to the overall insulating film also affect the fine structure to be formed in the insulating film. To get the highly dense structure with just a small number of gaps formed by the needle alumina particles and granular particles almost all over the insulating film as described above, the needle alumina particles preferably account for 0.3 mass% to 80 mass% of the overall insulating film. The reasons are as follows. Specifically, if the content of the needle alumina particles exceeded 80 mass%, then the needle alumina particles might aggregate together to create gaps between themselves. However, if the content of the needle alumina particles were less than 0.3 mass%, then the effects to be achieved by the addition of the needle alumina particles should not be achieved and the granular particles might aggregate together to create gaps between themselves.

To get the metal plate easily formed into a desired shape by a machining process, the metal plate preferably has a thickness of 0.05 mm to 0.5 mm. More particularly, the metal plate may be a stainless steel plate made of an Fe-Ni-Cr alloy or an Fe-Cr alloy, for example. The stainless steel plate exhibits excellent corrosion resistance in its cut face among other things. Alternatively, the metal plate may also be made of an Fe-Ni alloy, Fe, Al, or Cu. A metal plate of Al is advantageous considering its light weight. On the other hand, if the metal plate is made of Cu, then excellent thermal conductivity will be achieved.

To have a high breakdown voltage, the insulating film preferably has a thickness of at least 0.3 *µ*m and more preferably has a thickness of 1.0 *µ*m or more. The upper limit of the thickness is typically 3.5 *µ*m.

In the substrate of this preferred embodiment, when the insulating film is deposited to a thickness of 1 *µ*m, for example, on the metal plate, then the unevenness will be approximately equal to the surface roughness of the metal plate (of 0.3 *µ*m or less, for example).

Hereinafter, a method of making a substrate according to a preferred embodiment of the present invention will be described. In the following description, silica particles are supposed to be used as the granular particles.

A method of making a substrate according to a preferred embodiment of the present invention includes the steps of (a) preparing a dispersion solution including needle alumina particles and silica particles, (b) applying the dispersion solution onto a metal plate, (c) drying the metal plate on which the dispersion solution has been applied, and (d) baking the metal plate that has been subjected to the step of drying.

This manufacturing process uses a dispersion solution including particles. Accordingly, compared to a situation where a sputtering process is adopted, for example, a substrate including a coating on the surface of a metal plate can be obtained more efficiently. Also, the manufacturing process is simpler and requires a lower cost. The dispersion solution may be obtained by dispersing needle alumina particles and silica particles in water, for example.

The percentages of the needle alumina particles and silica particles to the overall dispersion solution are preferably defined such that the content of the needle alumina particles in the resultant insulating film will fall within the range of 0.3 mass% to 80 mass%. This is because the highly dense fine structure can be formed uniformly all over the film and no pinholes will be created in the insulating film in that case.

Furthermore, the dispersion solution is preferably prepared such that the combined concentration of the needle alumina particles and silica particles will fall within the range of 2 mass% to 6 mass%. In this concentration range, the needle alumina particles and silica particles can be dispersed well and a flat insulating film with small unevenness can be obtained.

To disperse those particles in the dispersion solution with stability, the dispersion solution preferably has its PH controlled within the range of 3.5 to 5.5. The PH of the dispersion solution may be controlled with at least one of formic acid, acetic acid, salts thereof, and ammonia. Optionally, to disperse the needle alumina particles and silica particles even more uniformly in the solution, a dispersant may be added if necessary. As the dispersant, sodium hexametaphosphorate may be used and added so as to have a concentration of about 0.1 mass% to the overall dispersion solution.

It may be determined by monitoring the variation in the transmittance of the dispersion solution with time, for example, whether or not the particles have been dispersed uniformly in the dispersion solution. More specifically, if no variation in transmittance is sensible with the eyes between the dispersion solution that has just been stirred up and the dispersion solution that has stood still for 0.5 to 1.0 hour after having been stirred up, those particles are regarded as being dispersed uniformly in the dispersion solution. In the manufacturing process of this preferred embodiment, if a dispersion solution where particles are dispersed uniformly is used, a flat insulating film with a small degree of surface unevenness, (e.g., with a surface roughness of 0.3 *µ*m or less) can be obtained.

The step (b) of applying the dispersion solution onto the metal plate is preferably carried out by a coating process. This is because the insulating film can be easily made on an industrial basis. More specifically, a dip coating process may be adopted. In the dip coating process, the metal base substrate is dipped in the dispersion solution and then lifted at an adjusted rate, thereby controlling the thickness of the resultant insulating film. More particularly, the higher the lifting rate, the thicker the insulating film can be.

The drying step (c) is carried out at a temperature of 80 °C to 120 °C. On the other hand, the backing step (d) is performed at a temperature of 450 °C to 750 °C.

Hereinafter, specific examples of the present invention and comparative examples will be described.

### Example No. 1

A substrate representing Example No. 1 was made in the following manner.

An aqueous solution, including needle alumina particles (with a major-axis length of 100 nm and an aspect ratio of 10) and silica particles (spherical particles with a mean particle size of 20 nm) at a combined concentration of 5 mass%, was prepared. Acetic acid was added to this aqueous solution and PH was adjusted to 4.5, thereby preparing a dispersion solution. The mass ratio of the needle alumina particles to the silica particles was set to 3:7.

Meanwhile, a metal plate of an Fe-Cr alloy (with dimensions of 50 mm ×50 mm ×0.1 mm) was prepared. This metal plate had a surface roughness Ra of 0.3 *µ*m. The metal plate was dipped in the dispersion solution, of which the temperature was set to 30 °C, for 60 seconds and then lifted from the dispersion solution (by a dip coating process). The dispersion solution was kept stirred up while the metal plate was dipped (i.e., until the metal plate dipped was lifted). The lifting rate was set to 0.3 m/min.

The metal plate coated with the dispersion solution in this manner was put into a drier, and heated to 100 °C and dried there. At this point in time, the coating had a thickness of 1.2 µm. The drying step was carried out by exposing the metal plate to hot air at a temperature of 100 °C for one hour. After having been dried, the metal plate was baked in the air for five minutes at a baking temperature of 550 °C. On these baking conditions, the insulating film could be baked sufficiently. The baking conditions were set such that the hardness of the insulating film on the metal plate would reach a certain value. In this example, a number of samples were baked for the same amount of time of five minutes but with the baking temperatures changed by 50 °C from one sample to another. After that, the hardness of each of these samples was measured. And if the difference in hardness between two samples, which had been baked at respective temperatures that were different from each other by 50 °C, was 2% or less, then those samples were regarded as having been well baked. The hardness was measured with a small hardness meter.

In this manner, an insulating film with a thickness of 1.0 *µ*m was obtained. The insulating film contained 31 mass% of alumina. The content of alumina in the insulating film was estimated with an EPMA.

### Example No. 2

A substrate representing Example No. 2 was made in the following manner.

An aqueous solution, including needle alumina particles (with a major-axis length of 100 nm and an aspect ratio of 10) and silica particles (spherical particles with a mean particle size of 20 nm) at a combined concentration of 5 mass%, was prepared. Acetic acid was added to this aqueous solution and PH was adjusted to 4.6, thereby preparing a dispersion solution. The mass ratio of the needle alumina particles to the silica particles was set to 1:9.

The same metal plate as the counterpart of Example No. 1 was prepared. An insulating film was formed on the surface of the metal plate by the same method as that described for Example No. 1. The temperature of the dispersion solution was set to 30 °C. The metal plate was dipped in this dispersion solution for 60 seconds and then lifted at a rate of 0.3 m/min from the dispersion solution. Thereafter, the metal plate was dried under the same conditions as those specified for Example No. 1 to obtain an insulating film with a thickness of 0.9 *µ*m, which was further baked after that. The baking conditions were also the same as those adopted for Example No. 1.

In this manner, an insulating film with a thickness of 0.7 µm was obtained. The content of alumina in the insulating film was 10 mass%.

### Example No. 3

A substrate representing Example No. 3 was made in the following manner.

An aqueous solution, including needle alumina particles (with a major-axis length of 80 nm and an aspect ratio of 7) and silica particles (spherical particles with a mean particle size of 30 nm) at a combined concentration of 3 mass%, was prepared. Acetic acid was added to this aqueous solution and PH was adjusted to 4.7, thereby preparing a dispersion solution. The mass ratio of the needle alumina particles to the silica particles was set to 7:3.

Meanwhile, a metal plate of an Fe-Ni alloy (with dimensions of 50 mm×50 mm×0.3 mm) was prepared. This metal plate had a surface roughness Ra of 0.2 µm. An insulating film was formed on the surface of the metal plate by the same method as that described for Example No. 1. The temperature of the dispersion solution was set to 30 °C. The metal plate was dipped in this dispersion solution for 60 seconds and then lifted at a rate of 0.3 m/min from the dispersion solution. Thereafter, the metal plate was dried under the same conditions as those specified for Example No. 1 to obtain an insulating film with a thickness of 0.5 *µ*m, which was further baked after that. The baking conditions were also the same as those adopted for Example No. 1.

In this manner, an insulating film with a thickness of 0.4 *µ*m was obtained. The content of alumina in the insulating film was 72 mass%.

### Example No. 4

A substrate representing Example No. 4 was made in the following manner.

An aqueous solution, including needle alumina particles (with a major-axis length of 120 nm and an aspect ratio of 10) and silica particles (spherical particles with a mean particle size of 30 nm) at a combined concentration of 5 mass%, was prepared. Acetic acid was added to this aqueous solution and PH was adjusted to 4.7, thereby preparing a dispersion solution. The mass ratio of the needle alumina particles to the silica particles was set to 7:3.

The same metal plate as the counterpart of Example No. 3 was prepared. An insulating film was formed on the surface of the metal plate by the same method as that described for Example No. 1. The temperature of the dispersion solution was set to 30 °C. The metal plate was dipped in this dispersion solution for 60 seconds and then lifted at a rate of 0.3 m/min from the dispersion solution. Thereafter, the metal plate was dried under the same conditions as those specified for Example No. 1 to obtain an insulating film with a thickness of 1.0 *µ*m, which was further baked after that. The baking conditions were also the same as those adopted for Example No. 1.

In this manner, an insulating film with a thickness of 0.8 *µ*m was obtained. The content of alumina in the insulating film was 74 mass%.

### Example No. 5

A substrate representing Example No. 5 was made by the same method, and under the same conditions, as those described for Example No. 1 except that needle alumina particles with an aspect ratio of five were used. The resultant insulating film had a thickness of 1.0 *µ*m. And the content of needle alumina particles in the insulating film was 32 mass%.

### Example No. 6

A substrate representing Example No. 6 was made by the same method, and under the same conditions, as those described for Example No. 1 except that spherical particles with a mean particle size of 90 nm were used as the silica particles. The resultant insulating film had a thickness of 1.2 *µ*m. And the content of needle alumina particles in the insulating film was 30 mass%.

### Example No. 7

A substrate representing Example No. 7 was made by the same method, and under the same conditions, as those described for Example No. 2 except that the needle alumina particles and silica particles were mixed at a mass ratio of 85:15. The resultant insulating film had a thickness of 0.8 µm. And the content of needle alumina particles in the insulating film was 88 mass%.

### Example No. 8

A substrate representing Example No. 8 was made by the same method, and under the same conditions, as those described for Example No. 2 except that needle alumina particles with a major-axis length of 350 nm were used. The resultant insulating film had a thickness of 0.7 *µ*m. And the content of needle alumina particles in the insulating film was 12 mass%.

### Comparative Example No. 1

A substrate representing Comparative Example No. 1 was made in the following manner.

The substrate was made by the same method, and under the same conditions, as those described for Example No. 1 except that only silica particles (spherical particles with a mean particle size of 20 nm) with no needle alumina particles were used as a material for the insulating film. The resultant insulating film had a thickness of 0.4 *µ*m.

### Comparative Example No. 2

In Comparative Example No. 2, a substrate was made by the same manufacturing process as that of Comparative Example No. 1 except that the drying process step was followed by another coating process step. The resultant insulating film had a thickness of 0.8 *µ*m.

### Comparative Example No. 3

A substrate representing Comparative Example No. 3 was made in the following manner.

The substrate was made by the same method, and under the same conditions, as those described for Example No. 3 except that the needle alumina particles were replaced with granular alumina particles (spherical particles with a mean particle size of 80 nm) in the material for the insulating film for Example No. 3. The resultant insulating film had a thickness of 0.4 *µ*m.

### Evaluation

To evaluate the properties of the substrates representing specific examples of the present invention and the comparative examples, those substrates were subjected to a 90 degree bending test, a pinhole test and an SEM analysis.

In the 90 degree bending test, each substrate was bent 90 degrees with a load applied onto the center of the substrate to see if the insulating film on the surface of the metal plate peeled off. This 90 degree bending test was carried out three times on each sample.

In the pinhole test, the insulating film on the surface of each metal plate was subjected to a corrosion resistance test compliant with JIS-H-8617 (which is also called a "ferroxyl test") and then the electrical resistance thereof was measured with tester probes brought into contact with predetermined points (e.g., at 10 points selected at intervals of 5 mm) on the insulating film. If the electrical resistance was higher than 200 Ω, then the insulating film was regarded as having no electrical continuity and having no pinholes, i.e., evaluated as exhibiting excellent corrosion resistance and insulating property. On the other hand, if the electrical resistance was 200 Ω or less, then the insulating film was regarded as having some electrical continuity and pinholes.

As a result of the SEM analysis on the surface of each insulating film, if alumina particles and silica particles were found distributed almost all over the insulating film and if a highly dense and fine structure with just a small number of gaps was found formed by the alumina and silica particles, then that insulating film was regarded as coating the metal plate uniformly.

### Results

The results of the 90 degree bending test, pinhole test and SEM analysis that were carried out on Examples Nos. 1 through 8 and Comparative Examples No. 1 through 3 and overall ratings thereof are shown in the following Table 1. As to the overall rating, if the results of the bending test, pinhole test and SEM analysis were all good (i.e., if the insulating film never peeled off after having gone through the 90 degree bending test, and if the insulating film showed substantially no electrical continuity after having gone through the pinhole test, and if the insulating film was regarded as coating the surface of the metal plate substantially uniformly), then that insulating film was rated good (as represented by the open circle ○). Otherwise, the insulating film was rated no good (as represented by the cross ×). Also, if no aggregating portions or gaps were found in an insulating film on the surface of the metal plate as a result of the SEM analysis, then the insulating film was rated excellent (as represented by the double circle ⊚).

**Table 1**

| | Bending test | Pinhole test | SEM analysis | Overall rating |
|---|---|---|---|---|
| Ex.1 | Never peeled | Non-continuous | Uniformly coated | ⊚ |
| Ex.2 | Never peeled | Non-continuous | Uniformly coated | ⊚ |
| Ex.3 | Never peeled | Non-continuous | Uniformly coated | ⊚ |
| Ex.4 | Never peeled | Non-continuous | Uniformly coated | ⊚ |
| Ex.5 | Never peeled | Non-continuous | Almost uniformly coated (but some needle alumina aggregated) | ○ |
| Ex.6 | Never peeled | Non-continuous | Almost uniformly coated (but few small gaps made) | ○ |
| Ex.7 | Slightly Peeled Locally | Almost non-continuous (but few conductive portions present) | Almost uniformly coated (but some needle alumina aggregated) | ○ |
| Ex.8 | Slightly Peeled Locally | Almost non-continuous (but few conductive portions present) | Almost uniformly coated (but few small gaps made) | ○ |
| Comp. Ex.1 | Peeled | Continuous | Coated insufficiently with noticeable gaps | × |
| Comp. Ex.2 | Peeled | Continuous | Coated insufficiently with noticeable gaps | × |
| Comp. Ex.3 | Peeled | Continuous | Coated insufficiently with noticeable gaps | × |

As can be seen from the results shown in Table 1, the present inventors discovered that an insulating film including needle alumina particles and silica particles in combination as in the substrates representing Examples Nos. 1 through 8 did not peel off the metal plate easily and exhibited very good corrosion resistance and insulating property (i.e., had excellent insulating and other physical properties). The results of the SEM analysis also revealed that such an insulating film covered the surface of the metal plate uniformly.

In contrast, the present inventors also discovered that an insulating film consisting essentially of silica particles as in Comparative Example No. 1 and an insulating film including granular alumina particles and silica particles in combination as in Comparative Example No. 3 exhibited inferior insulating and other physical properties. The results of the SEM analysis also revealed that gaps were created between those granular particles. We also discovered that even a relatively thick insulating film consisting essentially of silica particles as in Comparative Example No. 2 could not exhibit improved physical properties, either, and failed to prevent gaps from being created between the granular particles.

Taking these results into consideration, it can be seen that if granular particles are used by themselves, no highly dense fine structure with a small number of gaps can be formed, and no insulating film with desired insulating and other physical properties can be obtained, either. Meanwhile, it can also be seen that if an insulating film is made of needle alumina particles and granular particles in combination, the needle alumina particles and granular particles can be distributed almost all over the insulating film and a highly dense fine structure with just a small number of gaps can be formed of the needle alumina particles and granular particles. And the present inventors discovered that the insulating and other physical properties of the insulating film could be improved significantly by that fine structure formed by the needle alumina particles and granular particles. We also discovered that in an insulating film consisting essentially of granular particles, even if the thickness of the insulating film was increased, no highly dense fine structure with a small number of gaps could be formed and no insulating film with desired physical properties could be obtained, either.

It can be seen that comparing the results of Examples Nos. 1 and 5 with each other, the needle alumina particles preferably have a relatively large aspect ratio (e.g., more than 5). It can also be seen that comparing the results of Examples Nos. 1 and 6 with each other, the spherical particles should not have too large a mean particle size (e.g., less than 90 nm). Moreover, it can also be seen that comparing the results of Examples Nos. 2 and 7 with each other, the percentage of the needle alumina particles should not be too high (e.g., less than 88 mass%). Furthermore, it can also be seen that comparing the results of Examples Nos. 2 and 8 with each other, the needle alumina particles should not have too long a major axis (e.g., less than 350 nm).

### Example No. 9

Four samples (i.e., Samples Nos. 1 through 4) were made with the major-axis length and aspect ratio of the needle alumina particles changed, and subjected to the 90 degree bending test, pinhole test and SEM analysis, the details of which are just as described above.

Each of these four samples included needle alumina particles and silica particles as a material for the insulating film. Spherical particles with a mean particle size of 30 nm were used as the silica particles and the mass ratio of the needle alumina particles to the silica particles in the insulating film was adjusted to 7:3. An iron plate with dimensions of 50 mmX50 mm× 0.2 mm was used as the metal plate of the base substrate and an insulating film was deposited to a thickness of 0.4 *µ*m on the surface of the iron plate.

The results of the bending test, pinhole test and SEM analysis on Example No. 9, along with the overall rating thereof, are shown in the following Table 2:

**Table 2**

| Sample No. | Major-axis length (nm) of needle alumina particles | Aspect ratio of needle alumina particles | Pinhole test | SEM analysis | Overall rating |
|---|---|---|---|---|---|
| 1 | 500 | 10 | Continuous | Coated insufficiently with alumina and silica particles separated | × |
| 2 | 400 | 6 | Continuous | Coated insufficiently with alumina and silica particles separated | × |
| 3 | 300 | 10 | Non-continuous | Uniformly coated | ○ |
| 4 | 100 | 10 | Non-continuous | Uniformly coated | ○ |

As can be seen from the results shown in Table 2, the major-axis size and aspect ratio of the needle alumina particles affected the configuration of the fine structure that was formed in the insulating film and the physical properties of the insulating film.

It was discovered that an insulating film, of which the needle alumina particles had a major-axis length of more than 300 nm (as in Samples Nos. 1 and 2), exhibited low physical properties. The results of the SEM analysis also revealed that in the insulating film of Samples Nos. 1 and 2, the needle alumina particles and the silica particles separated from each other and there were an area where the needle alumina particles aggregated together and an area where the silica particles aggregated together.

In contrast, it was discovered that an insulating film, of which the needle alumina particles had a major-axis length of 300 nm or less (as in Samples Nos. 3 and 4), exhibited high insulating and other physical properties. The results of the SEM analysis also revealed that the insulating film covered the surface of the metal plate uniformly.

Although no detailed results are shown specifically, it was discovered that the aspect ratio of the needle alumina particles also affected the configuration of the fine structure that was formed in the insulating film and the physical properties of the insulating film. The smaller the aspect ratio of the needle alumina particles, the closer to a sphere the shape of the alumina particles becomes. In that case, the highly dense fine structure with a small number of gaps cannot be formed.

Taking these results into consideration, the present inventors discovered that by appropriately adjusting the major-axis size and aspect ratio of the needle alumina particles, the alumina particles and silica particles could be distributed uniformly almost all over the insulating film and a highly dense fine structure with a small number of gaps could be formed by those alumina and silica particles. We also discovered that the fine structure formed by these alumina and silica particles could improve the insulating and other physical properties of the insulating film.

### Example No. 10

In this specific example, to evaluate the heat resistance of the substrate of the present invention, four samples (i.e., Samples Nos. 5 through 8) were made with the baking temperature or thickness of the insulating film changed. Each of these four samples included needle alumina particles and silica particles as a material for the insulating film. Spherical particles with a mean particle size of 30 nm were used as the silica particles. The needle alumina particles had a major-axis size of 100 nm and an aspect ratio of 10. The mass ratio of the needle alumina particles to the silica particles in the insulating film was adjusted to 7:3. A metal plate made of an Fe-Ni alloy with dimensions of 50 mm × 50 mm × 0.099 mm was used as the metal plate of the base substrate.

These four samples were heated to 900 °C for 10 minutes and then subjected to the 90 degree bending test and pinhole test.

The results of the bending test, pinhole test and SEM analysis on Example No. 6, along with the overall rating thereof, are shown in the following Table 3:

**Table 3**

| Sample No. | Baking temperature (°C) | Thickness (*µ*m) of insulating film | Bending test | Pinhole test | SEM analysis | Overall rating |
|---|---|---|---|---|---|---|
| 5 | 500 | 0.5 | Never peeled | Non-continuous | Uniformly coated | ○ |
| 6 | 600 | 0.5 | Never peeled | Non-continuous | Uniformly coated | ○ |
| 7 | 600 | 0.7 | Never peeled | Non-continuous | Uniformly coated | ○ |
| 8 | 750 | 0.7 | Never peeled | Non-continuous | Uniformly coated | ○ |

As can be seen from the results shown in Table 3, each of the sample substrates Nos. 5 through 8 representing Example No. 10 maintained high physical properties even after having been heated to 900 °C. The results of the SEM analysis also revealed that the insulating film still covered the surface of the metal plate uniformly even after having been heated to 900 °C.

Consequently, it was discovered that the substrate representing Example No. 10 could resist a heat of 900 °C or more.

### INDUSTRIAL APPLICABILITY

A substrate according to the present invention can be used to make a wiring board for any of various types of electronic devices. The substrate of the present invention has excellent insulating property, heat resistance, and other physical properties, and can be used in a control panel for cars, for example.

## Claims

1. A substrate comprising
a metal plate, and
an insulating film, which is provided on the surface of the metal plate and which includes needle alumina particles and granular particles.

2. The substrate of claim 1, wherein the granular particles include at least one of silica particles, MgO particles, and TiO₂ particles.

3. The substrate of claim 2, wherein the granular particles include silica particles.

4. The substrate of one of claims 1 to 3, wherein the needle alumina particles have an aspect ratio of 6 to 15.

5. The substrate of claim 4, wherein the needle alumina particles have a major-axis length of 70 nm to 300 nm.

6. The substrate of one of claims 1 to 5, wherein the granular particles have a mean particle size of 5 nm to 80 nm.

7. The substrate of one of claims 1 to 6, wherein the insulating film includes 0.3 mass% to 80 mass% of the needle alumina particles.

8. The substrate of one of claims 1 to 7, wherein the insulating film has a thickness of 0.3 µm to 3.5 µm.

9. The substrate of one of claims 1 to 8, wherein the insulating film has a surface roughness of 0.3 µm or less.

10. The substrate of one of claims 1 to 9, wherein the metal plate is made of Cu, an Fe-Ni-Cr alloy, an Fe-Cr alloy, an Fe-Ni alloy, Fe or Al.

11. The substrate of one of claims 1 to 10, wherein the metal plate has a thickness of 0.05 mm to 0.5 mm.

12. A wiring board comprising
the substrate of one of claims 1 to 11, and
a wiring pattern that has been formed on the surface of the insulating film on the substrate.

13. A method of making a substrate, comprising the steps of:
preparing a dispersion solution including needle alumina particles and granular particles;
applying the dispersion solution onto a metal plate;
drying the metal plate on which the dispersion solution has been applied; and
baking the metal plate that has been subjected to the step of drying, thereby forming an insulating film on the surface of the metal plate.

14. The method of claim 13, wherein the step of applying the dispersion solution is carried out by a coating process.

15. The method of claim 13 or 14, wherein the dispersion solution is prepared so as to have a PH of 3.5 to 5.5.

16. The method of claim 15, wherein the dispersion solution includes at least one of formic acid, acetic acid, salts thereof, and ammonia.

17. The method of one of claims 13 to 16, wherein the combined concentration of the needle alumina particles and the granular particles in the dispersion solution is 2 mass% to 6 mass%.

18. The method of one of claims 13 to 17, wherein the granular particles include silica particles.

19. The method of one of claims 13 to 18, wherein the needle alumina particles have an aspect ratio of 6 to 15.

20. The method of one of claims 13 to 19, wherein the granular particles have a mean particle size of 5 nm to 80 nm.

21. The method of one of claims 13 to 20, wherein the insulating film includes 0.3 mass% to 80 mass% of the needle alumina particles.
